# EUROPEAN PATENT SPECIFICATION

(11) **EP 1 127 381 B1**
(45) Date of publication and mention of the grant of the patent: **23.09.2015**
(21) Application number: 99956881.9
(22) Date of filing: 02.11.1999
(51) Int. Cl.: H01L 51/00, H01L 51/52, G02F 1/1333, C23C 16/02, C23C 16/54

(54) **TRANSPARENT CONDUCTIVE OXIDES FOR PLASTIC FLAT PANEL DISPLAYS**
TRANSPARENTE LEITFÄHIGE OXIDE FÜR KUNSTSTOFF-FLACHBILDSCHIRME
OXYDES CONDUCTEURS TRANSPARENTS POUR ECRAN PLAT EN PLASTIQUE

(30) Priority: 02.11.1998 US 106871 P; 18.10.1999 US 419870
(43) Date of publication of application: 29.08.2001
(73) Proprietor: 3M Innovative Properties Company, Saint Paul, MN 55133-3427 (US)
(72) Inventor: BRIGHT, Clark, I., Tucson, AZ 85743 (US)
(74) Representative: Vossius & Partner Patentanwälte Rechtsanwälte mbB
(86) International application number: PCT/US1999/025843
(87) International publication number: WO 2000/026973

(56) References cited:
- EP-A- 0 260 626
- EP-A- 0 977 469
- WO-A-92/12219
- JP-A- H0 448 515
- US-A- 5 547 508
- US-A- 5 757 126
- PATENT ABSTRACTS OF JAPAN vol. 1998, no. 03, 27 February 1998 (1998-02-27) -& JP 09 291356 A (ASAHI GLASS CO LTD), 11 November 1997 (1997-11-11)
- PATENT ABSTRACTS OF JAPAN vol. 018, no. 641 (E-1639), 6 December 1994 (1994-12-06) -& JP 06 251631 A (KANEGAFUCHI CHEM IND CO LTD), 9 September 1994 (1994-09-09)
- PATENT ABSTRACTS OF JAPAN vol. 016, no. 582 (E-1300), 22 December 1992 (1992-12-22) -& JP 04 230906 A (UNITIKA LTD), 19 August 1992 (1992-08-19)
- DATABASE WPI Section Ch, Week 198744 Derwent Publications Ltd., London, GB; Class A85, AN 1987-309622 XP002130779 -& JP 62 217506 A (UNITIKA LTD), 25 September 1987 (1987-09-25)
- AFFINITO J D ET AL: "A NEW METHOD FOR FABRICATING TRANSPARENT BARRIERS LAYERS" THIN SOLID FILMS,CH,ELSEVIER-SEQUOIA S.A. LAUSANNE, vol. 290/291, 15 December 1996 (1996-12-15), pages 63-67, XP000693807 ISSN: 0040-6090

## Description

### FIELD OF THE INVENTION

This invention relates to composite substrates for flat panel displays (FPD), packaging materials and light sources (electro luminescence lamps) comprising a plastic substrate having thin film barrier and conductive layers, in particular, multiple thin alternating layers of tansparent conductive oxide (TCO), and organic polymers deposited over the plastic substrate.

### BACKGROUND OF THE INVENTION

The use of portable electronic devices incorporating flat panel displays is prevalent and increasing rapidly. Because of the portable nature of these devices, it is desired to minimize both the size and weight and maximize durability. The display portion of the device is generally larger and denser as compared to the rest of the device, and is manufactured on glass substrates. Accordingly, a smaller, lighter and more durable portable electronic device is most effectively achieved with a smaller, lighter and shatterproof electronic device display.

Despite being lightweight, plastic has not been considered a viable substrate material so be used for the manufacture of flat panel displays for multiple reasons. Most importantly, flat panel displays with plastic substrates tend to fail prematurely due to degradation of the display, medium and some metallic electrodes. In particular, the display medium and some metallic electrodes become degraded when atmospheric oxygen and water permeate the substrate and chemically degrade the active portion of the display matrix, which is generally comprised of liquid crystals and/or light emitting devices. Second, common optical quality plastic substrates, e.g. polyethylene terephthalate (PET), have limited thermal properties. In particular, there is a limited temperature range that allows useful optical quality (e.g. clarity, transparency, uniform index of refraction) to be maintained, while maintaining the requisite mechanical strength and properties of the substrate.

EP 0 977 469 (A2) describes a barrier for preventing water or oxygen from reaching a device that is sensitive to water or oxygen. The barrier is constructed by depositing a first polymer layer between the device and the source. An inorganic layer is deposited on the first polymer layer of the device by plasma enhanced chemical vapor deposition utilizing an electron cyclotron resonance source ECR-PECVD. A second polymer layer is then deposited on the inorganic layer. The inorganic layer is preferably an oxide or nitride. A second barrier layer having a compound that absorbs oxygen or water can be placed between the inorganic layer and the device to further retard the passage of oxygen or water.

JP 9 291356 (A) describes a method wherein a transparent oxide layer 2, a metallic layer 3, a transparent oxide layer 4 and a coating layer 11 are formed on a backing substrate 1. Zinc oxide as the main component of the transparent oxide layer 2 promotes the crystallization of Ag in the metallic layer 3. An indium oxide containing coating layer 11 is formed above the transparent layer 4. A plastic substrate low in heat resistance is used.

JP 6 251631 (A) decribes a method wherein a transparent inorganic thin film of barrier quality substantially impermeable to oxygen and water vapor is formed on a transparent film substrate. Aromatic polyester, aromatic polyacrylate, or polycarbonate is used for the substrate, and metallic oxide mainly composed of silicon oxide and/or metallic nitride mainly composed of silicon nitride is suitable for the thin film of barrier quality. Then, a transparent conductive thin film of metallic oxide mainly composed of indium oxide is formed on the thin film, preferably by using a magnetron sputtering method.

US 4,799,745 (A) describes a transparent, infrared reflecting composite film including a transparent metal layer-dielectric layer filter adhered to one side of a transparent support, employing as the transparent metal layer-dielectric layer filter a visible light-transmitting infrared-reflecting Fabry-Perot interference filter which includes at least two separate discrete continuous sputter-deposited transparent metal layers separated from one another by a discrete continuous spacer layer of sputter-deposited inorganic metal oxide, compound or salt dielectric wherein each transparent metal layer is contiguous with and directly adherent to the adjacent spacer layer of dielectric without an intervening nucleation layer.

JP 0 4048515 describes a composite substrate comprising polymer layers and a transparent conductive oxide layer.

### SUMMARY OF THE INVENTION

The present invention is directed to the fabrication of flat panel displays on lightweight, flexible, plastic substrates. Because plastic substrates for FPDs are flexible, smaller and lighter than glass substrates, the electronic device with the plastic FPD is more portable, space-efficient and lightweight. In addition, electroluminescent and organic light emitting devices fabricated on flexible polymeric substrates in a coating process have lower manufacturing costs than those with glass substrates, and improved ruggedness.

A display medium of the flat panel display is sandwiched between two electrode layers. At least one of the electrodes is transparent for viewing of the display. The display medium is protected from oxidative degradation. In the present invention, at least one layer, having both barrier characteristics and the ability to function as an electrode, is deposited over the substrate. In particular, the layer has both low oxygen and moisture permeability, and a low enough resistivity to function as an electrode for the display. For lower permeability and/or higher conductivity, multiple alternating layers of barrier materials and conductive materials are applied. In an alternative embodiment, the conductive layers are in direct contact. The barrier material includes at least one of an organic polymer, a transparent dielectric, a transparent metal nitride and/or a transparent conductive oxide. The conductive material includes at least one of a thin transparent conductive oxide, a thin transparent metallic film and/or a metal nitride.

A composite substrate according to the invention is described in claim 1 and a method for fabricating said substrate is described in claim 12.

Using a smoothing base coat layer over the plastic substrate imparts good optical quality throughout the substrate layers and provides a pristine surface for nucleation of the deposited conductive layer, e.g. TCO. The pristine surface smooths over any surface roughness of the plastic substrate, thereby adding to the FPD lifetime and optical quality. Additionally, a hardcoat layer is applied over the substrate in lieu of or in addition to the smoothing basecoat layer. The hardcoat layer provides increased barrier ability.

While the smoothing layer is applied by one of many well known non-vacuum liquid coating processes, e.g. preferably by Gravure, the base coat is fabricated through a polymer multilayer (PML) coating process. Related desirable coating processes are disclosed in U.S. Patents 5,547,508, 5,395,644, 5,260,095, U.S. Patent Application Number 08/939,594, filed September 29, 1997, entitled "*Plasma enhanced chemical deposition with low vapor pressure compounds"* herein incorporated by reference, Thin Film Processes II, chapters II-2, 4, 5, and IV-1, edited by John L. Vossen and Wermer Kern, Academic Press, 1991, ISBN 0-12-728251-3*,* Deposition Technologies for Films and Coatings, Developments and Applications, Rointan F. Bunshah et al, Noyes Publications, 1982, ISBN 0-8155-0906-5. Plasma PML processes (PML and liquid PML) are called liquid multilayer (LML) processes. The PML process for vacuum evaporation is used to deposit organic monomers over the plastic substrate. The organic monomer is then polymerized in-situ by electron beam or UV radiation. The PML process is compatible with physical vapor deposition processes for layers such as TCO layers. Both processes are carried out in combined sequences within a properly designed single vacuum chamber, however, multiple vacuum chambers are preferably used. The PML deposited organic polymer layer is used to produce substrate surface smoothing and improve barrier coatings in the multilayer structure. The benefit of a smooth substrate surface is that there is a clean surface for adhesion, nucleation, and growth of a deposited conductive layer, e.g. a TCO. Additionally, a PML deposited organic polymer layer provides protection of an underlying barrier layer in order to minimize holes or other defects in the layer so that there is low permeability.

A single layer coating with metal oxide layers, such as thin film dielectric coatings (alumina or silica or other certain metal oxides), or thick metallic film layers having optical densities greater than 2.0 on plastic flat panel displays does not tender low enough permeability for the processing and manufacture of these displays with acceptable lifetimes. Even where multiple layers of dielectrics, metals or the combination thereof are used, the improvement in performance is minimal. In order to provide barrier properties sufficient for optical quality plastic flat panel displays, a transparent dielectric barrier, such as SiO₂₋ₓ or Al₂O_{3-y}, is deposited over a plastic substrate. When dielectric layers are combined with PML deposited organic polymer layers, outstanding barrier properties are achieved on flexible plastic substrates. Alternatively to the dielectric layer, a barrier coating of ITO (called "indium tin oxide", which is actually "Tin doped indium oxide," a mixture of indium oxide and tin oxide) or another TCO barrier is deposited over the substrate. According to the present invention both TCO barrier layers and PML processed organic polymer layers are deposited over the plastic substrate. Moreover, in another alternative, both TCO barrier layers with PML processed organic polymer layers and the transparent dielectric barrier layers are deposited over the plastic or polymeric substrate. Multilayer structures of such organic and inorganic layers deposited over a plastic substrate exhibit significantly improved barrier properties as compared to inorganic, organic or metallic layers alone.

In an embodiment, a PML processed top coat polymer layer is applied before the previously deposited layer contacts a surface, such as a roller, thereby protecting the previously deposited layer. The PML processed top coat greatly enhances the exclusion of moisture and atmospheric gases that chemically degrade the display medium and decrease the device performance, even though the polymer topcoat is not, itself, a good barrier material.

Metal oxide dielectric barriers have previously been deposited by evaporation, sputtering, and chemical vapor deposition processes onto glass substrates. However, for achieving bulk material-like properties a high temperature deposition method is to be used which melts the plastic substrate, thereby negatively impacting the mechanical properties of the substrate. In the present invention, the PML process used for depositing an organic dielectric does not require such high temperatures and therefore does not significantly alter the mechanical properties of the substrate. However, organic polymer layers alone do not provide substantial barrier properties, particularly against water vapor.

When TCOs are deposited at low temperatures to accommodate the thermal and mechanical limits of the substrate, for example, by magnetron sputtering, electron-beam evaporation or plasma enhanced chemical vapor deposition (PECVD), the subsequent TCO coatings have less than bulk conductivity, i.e. low overall levels of conductivity. TCO films with a larger thickness deposited through these methods achieve acceptable conductive levels for portable electronic devices. However, these thick films of TCO are subject to cracking, crazing and, in some instances, delamination from the substrate, especially when they are processed by a heat treatment step or a coating process involving mechanical rollers (e.g. web coating). As a consequence, the TCO coating is deposited in a series of thin, separated layers, yet still maintain high conductive levels. Multiple thin layers of TCO avoid the problems associated with thicker layers, and advantageously are electrically connected in parallel to provide adequate electrical performance characteristics.

The thin layers of TCO are deposited in combination with the PML process, which leads to improved optical, electrical and mechanical performance. Superior surface properties (low surface roughness, and high optical quality), barrier properties (low vapor permeability) and mechanical properties result when TCO coatings are deposited by magnetron sputtering on a plastic substrate in combination with the PML process. Preferably, moderate annealing temperature conditions are used for TCO deposition. The resistivity of ITO ("Tin doped indium oxide"), a TCO, is a function of the oxygen and tin content, as well as the deposition conditions (e.g. temperature). Previously, low temperature depositions yielded high resistivity ITO layers, when a low resistivity for ITO was desired. The resistivity of ITO was shown to decrease with a thicker TCO layer. But as discussed previously, thick TCO layers are prone to cracking or crazing. Multiple thin layers of TCO, as described in the present invention, will not crack and will yield a lower resistivity. Moreover, the surface resistivity of a thin film of TCO in multiple layers is low for a given total film thickness, due to its improved microstructure.

In an embodiment, a polymer smoothing coating is deposited over the substrate. The smoothing coating is applied by a PML process or liquid coating. A TCO, metal nitride, or metal layer is then deposited over the smoothing layer. Additionally, multiple alternating layers of a protective polymer layer and an additional TCO is deposited. The alternating layers are of the same material, e.g. TCO/polymer/TCO, etc.

In another embodiment, a polymer smoothing coating layer is optionally deposited over the substrate. Additionally, multiple alternating layers of polymer layers and metal oxide are deposited over the substrate. A TCO layer is then deposited over the top of multiple alternating layers. These multiple alternating layers together with the TCO have adequate barrier and conductivity characteristics.

In yet another embodiment, a substrate is coated with a TCO layer, a metal coating, and another TCO layer. This three layer configuration is called "optically enhanced metal," or an induced transmission filter and has similar characteristics as a single TCO layer. With the optically enhanced metal good conductivity, optical transmission, and barrier properties are achieved. A similar structure of metal nitrides, e.g., silicon nitride, metal and another metal nitride layer functions equivalently.

According to the invention a substrate is alternatively coated with an inorganic layer (such as TCO), and polymer layers to provide both barrier and conductive properties.

### BRIEF DESCRIPTION OF THE DRAWINGS

The aspects of the present invention described above in summary and below in more detail as well as various advantageous aspects will become appreciated as the same becomes better understood with reference to the specification, claims and drawings wherein:
FIG. 1 is a cross-sectional view of a composite substrate for a flat panel display (FPD) of the present invention;
FIG. 2 is a cross-sectional view of an embodiment of conductive barrier layer 3 of FIG. 1;
FIG. 3 is a cross-sectional view of another embodiment of conductive barrier layer 3 of FIG. 1;
FIG. 4 is a cross-sectional view of another embodiment of conductive barrier layer 3 of FIG. 1;
FIG. 5 is a cross-sectional view of another embodiment of conductive barrier layer 3 of FIG. 1;
FIG. 6 is a cross-sectional view of another embodiment of conductive barrier layer 3 of FIG. 1;
FIG. 7 is a cross-sectional view of another embodiment of conductive barrier layer 3 of FIG. 1;
FIG. 8 is a schematic illustration of a coating apparatus for forming the conductive barrier layer of FIG. 1;
FIG. 9a is a schematic illustration of a laminating process for the FPD of FIG. 1;
FIG. 9b is a cross-sectional view of the FPD before undergoing a bonding process;
FIG. 9c is a cross-sectional view of the FPD after undergoing a bonding process;
FIG. 10 is a chart showing water permeability of an ITO film deposited on a polyethylene terephthalate (PET) substrate versus ITO film sheet resistance;
FIG. 11 is a chart showing water permeability of ITO film deposited on a PET substrate versus ITO film thickness;
FIG. 12 is a chart showing oxygen permeability of ITO film deposited on a PET substrate versus ITO film thickness;
FIG. 13 is a chart showing oxygen permeability of ITO film deposited on a PET substrate versus ITO film sheet resistance;
FIG. 14 is a chart showing transmittance and reflectance spectra (for an ITO layer over a silver film layer over an ITO layer over a PET substrate at a sheet resistance of 14 Ohms/Square) versus wavelength;
FIG. 15 is a chart showing transmittance and reflectance spectra (for an ITO layer over a PET substrate at a sheet resistance of 29 Ohms/Square) versus wavelength;
FIG. 16 is a chart showing transmittance and reflectance spectra (for an ITO layer over a PET substrate at a sheet resistance of 57 Ohms/Square) versus wavelength;
FIG. 17 is a chart showing transmittance and reflectance spectra (for an ITO layer over a PET substrate at a sheet resistance of 65 Ohms/Square) versus wavelength;
FIG. 18 is a chart showing transmittance and reflectance spectra (for an ITO layer over a PET substrate at a sheet resistance of 347 Ohms/Square) versus wavelength;
FIG. 19 is a cross-sectional view of an embodiment of a conductive barrier layer;
FIG. 20 is a cross-sectional view of an embodiment of conductive barrier layers of FIG. 1;
FIG. 21 is a cross-sectional view of an embodiment of conductive barrier layers of FIG. 1;
FIG. 22 is a cross-sectional view of an embodiment of conductive barrier layers of FIG. 1;
FIG. 23 is a cross-sectional view of an embodiment of conductive barrier layers of FIG. 1;
FIG. 24 is a cross-sectional view of an embodiment of conductive barrier layers of FIG. 1;
FIG. 25 is a cross-sectional view of an embodiment of conductive barrier layers of FIG. 1;
FIG. 26 is a cross-sectional view of an embodiment of conductive barrier layers of FIG. 1;
FIG. 27 is a cross-sectional view of an embodiment of conductive barrier layers of FIG. 1;
FIG. 28 is a cross-sectional view of an embodiment of conductive barrier layers of FIG. 1;
FIG. 29 is a cross-sectional view of an embodiment of conductive barrier layers of FIG. 1;
FIG. 30 is a cross-sectional view of an embodiment of conductive barrier layers of FIG. 1;
FIG. 31 is a cross-sectional view of an embodiment of conductive barrier layers of FIG. 1;
FIG. 32 is a cross-sectional view of an embodiment of conductive barrier layers of FIG. 1; and
FIG. 33 is a cross-sectional view of an embodiment of conductive barrier layers of FIG. 1.

### DETAILED DESCRIPTION OF THE INVENTION

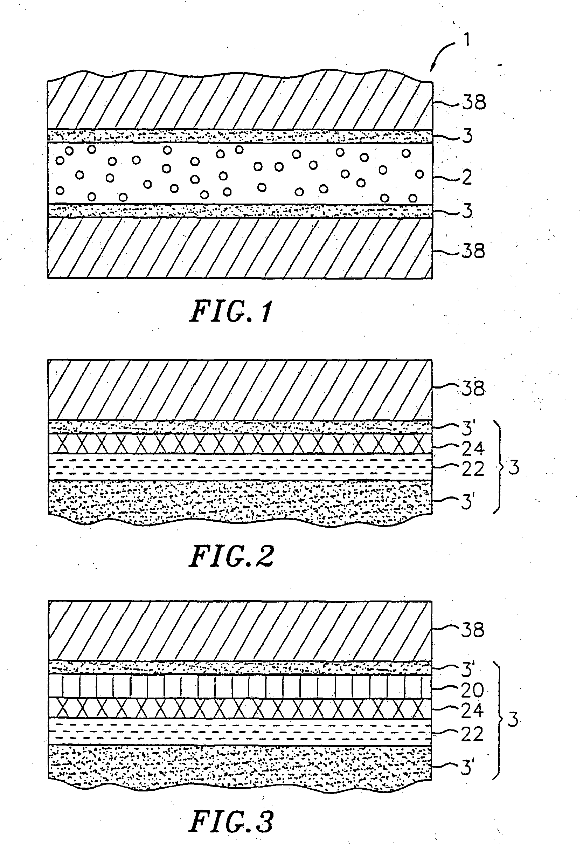

A flat panel display (FPD) 1, of the present invention as shown in FIG. 1, employs lightweight, flexible, plastic substrates 38 for constructing FPDs. In between two plastic substrates of the flat panel display are at least two electrodes. At least one of the electrodes is transparent for viewing of the display. A display medium 2 for the flat panel display is situated between the two electrodes. The display medium, as well as some electrode material, are protected from oxidative degradation and reaction or incorporation of moisture.

The displays are fabricated using plastic substrates such as various polyolefins, e.g. polypropylene (PP), various polyesters, e.g. polyethylene terephthalate (PET), and other polymers such as polyethylene napthalate (PEN), polyethersulphone (PES), polyestercarbonate (PC), polyetherimide (PEI), polyarylate (PAR), polyimide (PI), and polymers with trade names ARTON® (Japanese Synthetic Rubber Co., Tokyo, Japan) and AVATREL™ (B.F. Goodrich, Brecksville, Ohio).

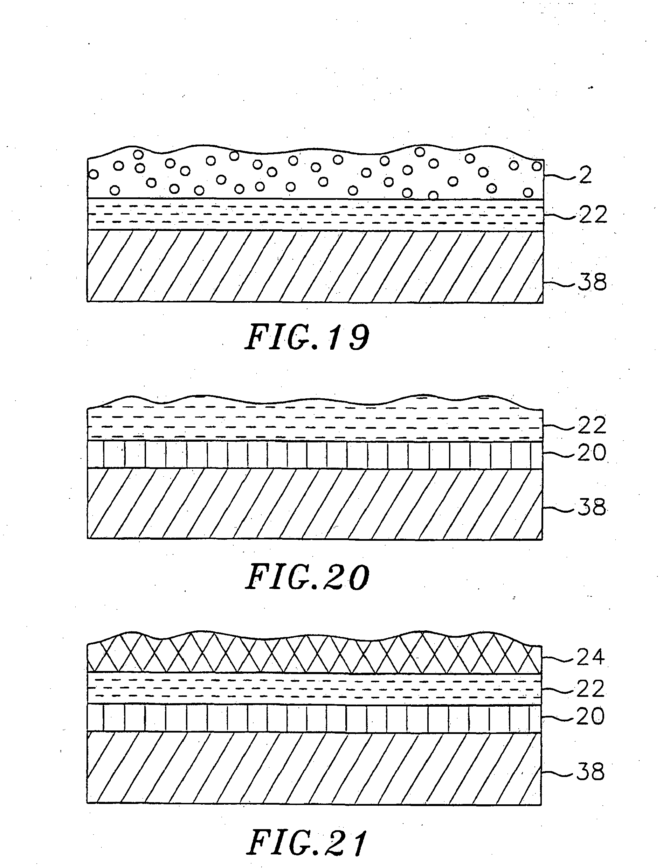

In the present invention, at least one layer, a conductive barrier layer 3 has both barrier characteristics (to protect the display medium and/or the metal electrode) and the ability to function as an electrode, and is deposited over the substrate to form a composite substrate, as shown in FIG. 19. In particular, layer 3 has both low oxygen and moisture permeability, and a low enough resistivity to function as an electrode for the display.

As shown in the general embodiments of FIGs. 2 through 7, conductive barrier layer 3 comprises at least one sublayer 3¹ deposited over the substrate, for instance a single ITO layer. In an embodiment, at least one pair of sublayers (a dyad of a polymer and a TCO, metal, or metal oxide) is deposited over the substrate. According to the invention multiple alternating sublayer pairs, comprised of the same materials as the original sublayer pair, are deposited over the substrate or over the previously deposited sublayer.

There are a myriad of possibilities for materials comprising the sublayers of the conductive barrier layer. FIGs. 2-7 illustrate generally only some of the more preferred embodiments of sublayer 3¹ materials for conductive barrier layer 3, while FIGS. 19-33 illustrate particularly the more preferred embodiments for the conductive barrier layer.

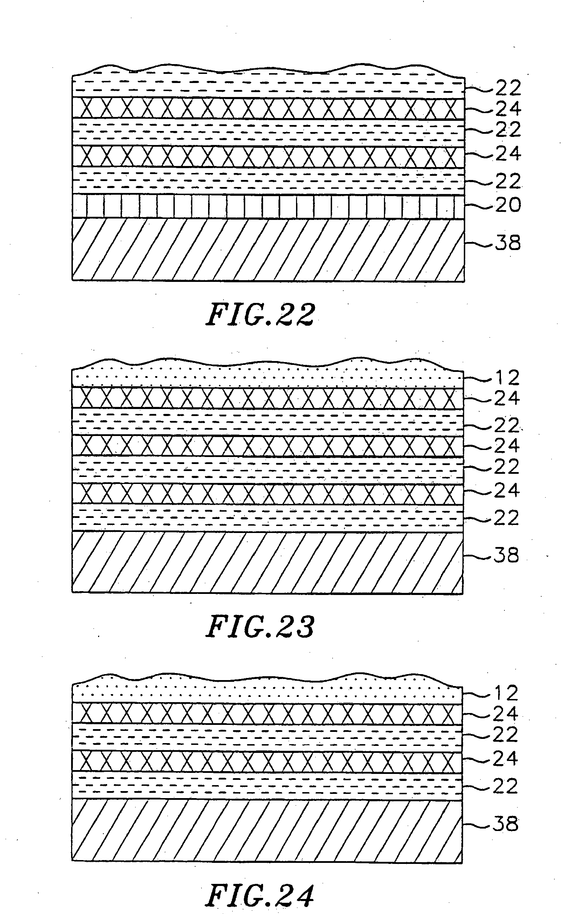

In an embodiment, a base coating 20 is deposited over the substrate 38. The base coating is a polymer smoothing coating applied by a PML process or an organic hardcoat deposited by a liquid coating process to render a hardcoated PET substrate that is abrasion resistant. A TCO 22 (or metal layer 12) is then deposited over the base coat, as shown in FIG. 3, and more particularly in FIG. 20. Additionally, multiple alternating layers of a protective polymer layer 24 and an additional TCO 22 (or metal layer 12) are additionally deposited, as represented by sublayer 3¹ in FIG. 3, and more particularly in FIGs. 21 and 22. The alternating layers are of the same material, e.g. TCO/polymer/TCO, etc. FIG. 2 illustrates the embodiment of polymer/TCO/polymer without base coat 20. Alternatively, a metal conductor or reflector 12 overlays the top polymer layer 24 as in FIGs. 23-25, and 30.

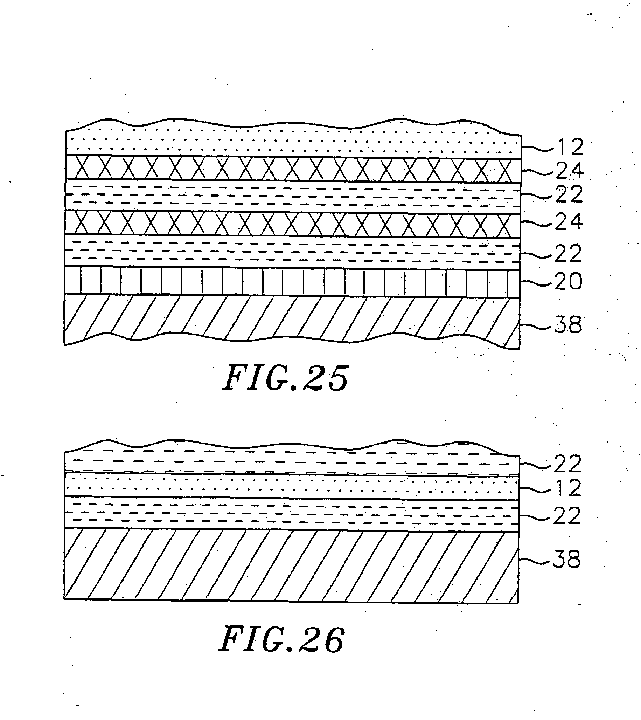

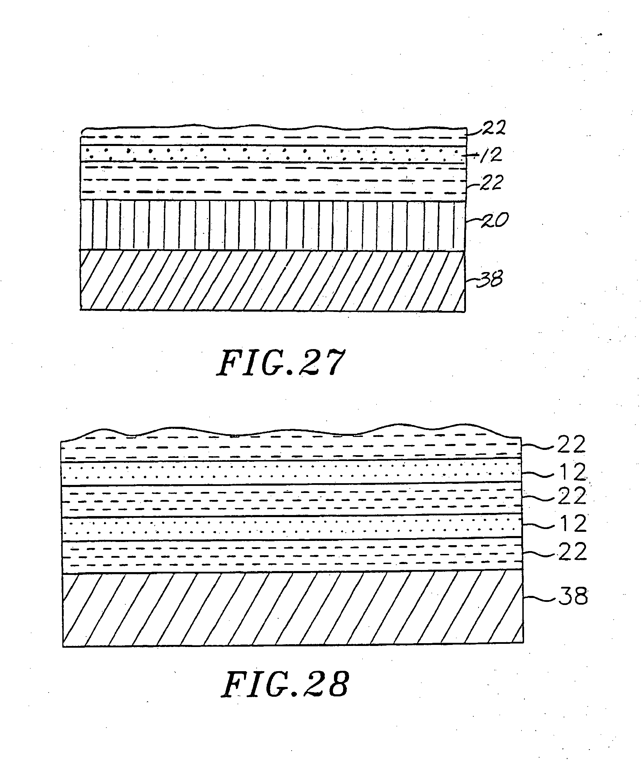

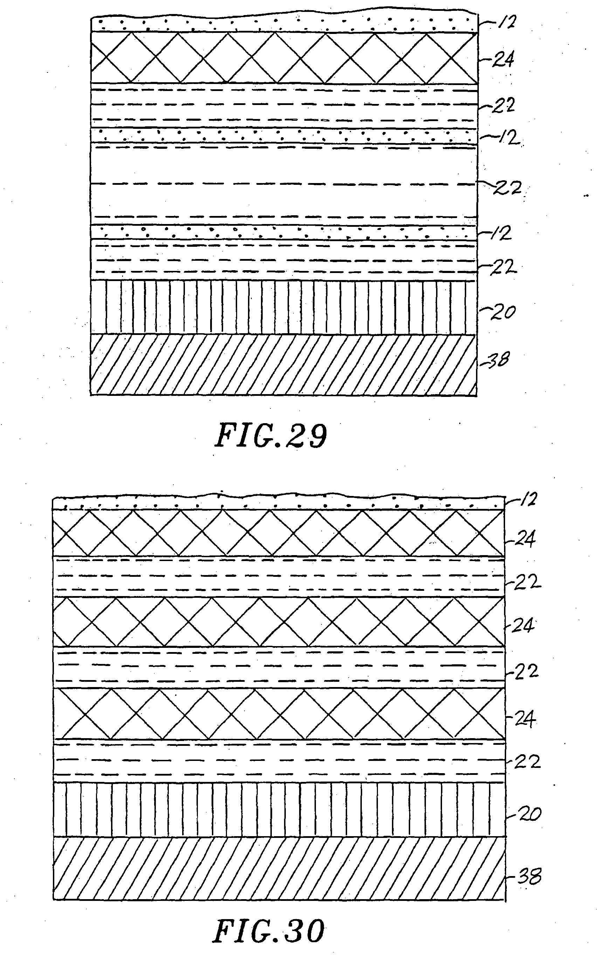

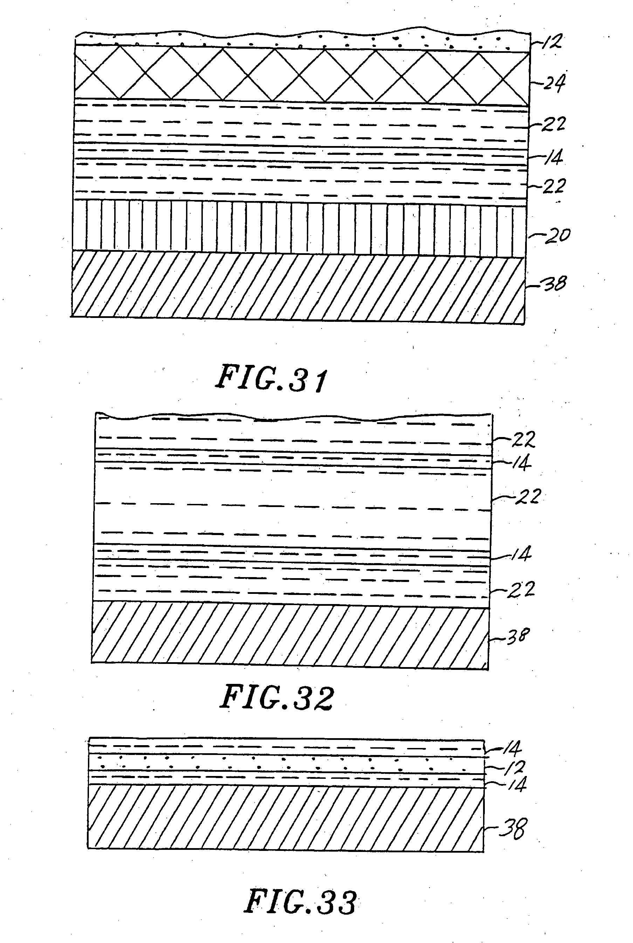

In another embodiment shown in FIG. 26, a substrate is coated with a TCO layer, a metal coating, and another TCO layer. This three layer configuration is called an "optically enhanced metal," and has characteristics similar to a single TCO layer. With the optically enhanced metal, good conductivity, transmission and barrier properties are achieved. Deposited on these three layers is preferably a polymer layer 24, that is alternating with the three layers. Alternatively, base coat 20 is deposited over the substrate as shown in FIG. 27. Additionally or alternatively, another dyad (a metal and TCO pair) is deposited over the top TCO layer, as shown in FIGs. 28 and 29. Additionally or alternatively as shown in FIG. 29, an additional polymer layer 24 (a polymer overcoat) is deposited over the previously deposited dyad. In another alternative, a thick metal layer 12 is deposited over the polymer overcoat layer, as also shown in FIG. 29. Alternatively, a metal nitride layer is substituted for one or more of the metal layers of these embodiments, for example, see FIGs. 31 and 32.

According to the present invention a substrate is alternatively coated with an inorganic layer (such as a TCO), and polymer layers to provide both barrier and conductive properties.

FIG. 33 illustrates a metal layer 12 sandwiched between two metal nitride layers 14. Alternatively, additional dyads (metal and metal nitride pair) are deposited over the metal nitride layer. Further embodiments of this dyad pair are similar to the TCO/ metal dyad pair embodiments of FIGs. 26-29, i.e. the TCO layers of FIGs. 26-29 are replaced by one or more metal nitride layers.

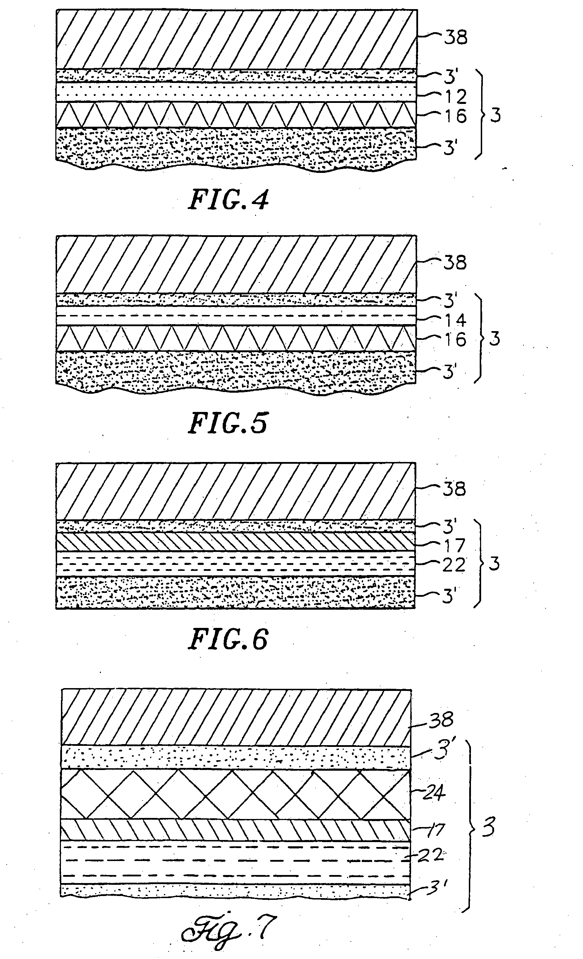

In an alternative embodiment, a dielectric layer replaces one or more TCO layers in the above described embodiments (see generally FIGs. 6 and 7). As shown in FIG. 7, multiple alternating layers of dielectric 17 and polymer layers 24 are deposited over the substrate 38. The number of multiple alternating layers (or dyads) vary, and is represented here by 3¹, sublayers of the conductive barrier layer 3. A TCO layer 22 is then deposited over the top of multiple alternating layers. These multiple alternating layers together with the TCO have adequate barrier and conductivity characteristics as described in more detail below.

Each TCO layer 22 of the above embodiments is a single TCO layer. Alternatively, the TCO layer represents two TCO layers.

Preferably, metal layers that are alternating dyad pairs or in between TCO, metal nitride, or dielectric layers are thin. In addition, metal layers that are adjacent the display matrix, i.e. overlaying the dyad layers, have a greater thickness than the sandwiched metal layers.

Sublayer 3' materials that provide barrier properties are thin transparent metal oxides 16, and/or thin transparent metallic films 12. The polymers 24 enhance barrier properties by reducing the number of holes and defects in the films upon which or under which, they are deposited. The metal oxide layers alternatively comprise dielectric layers 17 and/or transparent conductive oxide layers 22. The thickness for these barrier layers are in the nanometer and angstrom range. The thickness for the PML deposited layers are in the micron range. For example, improved barrier coating occurs when a PML deposited organic polymer layer (a base coat), and/or a metal oxide layer is placed over the plastic substrate. See Tables 2 and 3.

Sublayer 3¹ materials that provide conductive properties include a thin TCO 22, a thin transparent metallic film 12 (such as aluminum, silver, copper, gold, platinum, palladium, and alloys thereof), and a metal nitride 14 (such as transition metal nitrides, for example, titanium nitride, zirconium nitride, hafnium nitride, and nitrides of Group IVA, VA, and VIA elements of the Periodic Table, as well as nitrides of Group IIIB and IVB elements of the Periodic Table, for example: gallium nitride, silicon nitride, and aluminum nitride). The thickness for these conductive layers are in the nanometer and angstrom range. Preferably the TCO is formed by multiple thin layers deposited with electrical contact to each other, so that a low resistivity is achieved. Consequently, the TCO functions as both the electrode and a barrier.

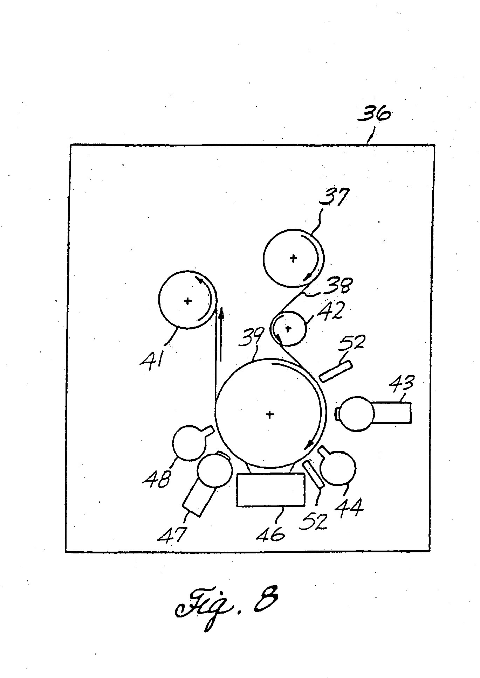

In the preferred embodiment, there is a PML processed base coat 20 deposited over the substrate as shown in FIG. 3. The base coat produces substrate smoothing, and more importantly, in combination with other layers, the base coat has surprisingly effective vapor barrier enhancement properties because of the smoothing and protection characteristics. The sublayers are deposited in combination with the process illustrated in FIG. 8.

Using a smoothing base coat layer over the plastic substrate imparts good optical and barrier quality throughout the substrate layers and provides a pristine surface for nucleation of the deposited TCO electrode layer. The pristine surface smooths over any surface roughness of the plastic substrate, thereby adding to the FPD lifetime and optical quality.

In an exemplary embodiment, one or more metal oxide layers are replaced with a TCO. When TCO coatings, including ITO ("Tin doped indium oxide"), cadmium oxides (CdSn₂O₄, CdGa₂O₄, CdIn₂O₄, CdSb₂O₆, CdGeO₄), tin oxides, indium oxides (In₂O₃: Ga, GaInO₃ (Sn, Ge), (GaIn)₂O₃), zinc oxides (ZnO(Al), ZnO(Ga), ZnSnO₃, Zn₂SnO₄, Zn₂In₂O₃, Zn₃In₂O₆), and/or magnesium oxides (MgIn₂O₄, MgIn₂O₄ - Zn₂In₂O₅) are deposited on a plastic substrate at a low temperature, they have an amorphous micro structure. The amorphous structure and oxygen deficiency of the TCO allow the TCO coating to exhibit conductive properties and barrier properties similar to transparent dielectric barrier layers, such as types of silica or alumina. Because of the oxygen deficiency, the barrier layers gather the oxygen and keep the oxygen from passing through. Multiple thin layers of TCO function as a transparent electrode and a transparent barrier layer. The benefit of using TCO alternating with metallic film layers, besides the barrier properties, is that all the layers of the structure are conductive, thus improving conductivity.

In the preferred embodiment, a suitable apparatus for coating the substrate with conductive and barrier layers is illustrated schematically in FIG. 8. All of the coating equipment is positioned in a vacuum chamber 36. A roll of polypropylene, polyester or other suitable plastic sheet is mounted on a pay-out reel 37. Plastic sheet 38 forming the substrate is wrapped around a first rotatable drum 39, and fed to a take-up reel 41. A roll 42 is employed, as appropriate, for guiding the sheet material from the payout reel to the drum and/or to the take-up reel.

A flash evaporator 43 is mounted in proximity to the drum at a first coating station. The flash evaporator deposits a layer or film of monomer, typically an acrylate, on the substrate sheet as it travels around the drum. After being coated with a monomer, the substrate sheet passes an irradiation station where the monomer is irradiated by a source 44 such as an electron gun or source of ultraviolet radiation. The radiation or electron bombardment of the film induces polymerization of the monomer.

The sheet then preferably passes a sputtering station 46 where a coating of TCO is applied by magnetron sputtering. The sheet then passes another flash evaporator 47 where another layer of monomer is deposited over the TCO layer. Depending on whether a layer of monomer is above or below the TCO layer, either evaporator 43 or 47 is used. Clearly, if the TCO layer is to be sandwiched between layers of polymer, both evaporators and their respective radiation sources are used. In addition to magnetron sputtering, the TCO layer is processed by one of thermal evaporation, chemical vapor deposition, plasma enhanced chemical vapor deposition, and electron beam evaporation. Chemical vapor deposition is a high temperature process, and is therefore the least desirable for use with plastic substrates.

In an alternative embodiment, a liquid PML (called Liquid Multilayer, LML) smoothing applicator 52 is mounted in proximity to the drum at a first coating station. The liquid smoothing applicator deposits a layer of monomer, e.g. acrylate, over the substrate. This layer of monomer is cured by irradiation from an ultraviolet or electron beam source 48 adjacent the drum. Additionally, the sheet then passes sputtering station 46 where a coating of thin metal film, metal oxide, and/or metal nitride is applied by one of vacuum sputtering, vacuum metallizing, plasma assisted chemical vapor deposition, or electron beam evaporation. For example, silicon oxides is deposited by a plasma enhanced chemical vapor deposition process using a metal organic precursor and an oxidizing or inert carrier gas.

The various layers described are deposited in several processes in addition to vacuum coating techniques. For instance, the layers are deposited through nonvacuum (atmospheric) roll coating. Alternatively or additionally, the layers are deposited by an in line coating machine, whereby a conveyor belt runs the substrate to be coated past multiple coating stations. In a further alternative, the layers are deposited by an intermittent motion machine, that is either in a vacuum processor a nonvacuum process. In yet another alternative, the layers are coated using a multitude of machines. For instance, the plastic substrate is first coated through atmospheric roll coating with a cured polymer and subsequently coated by vacuum deposition, or liquid coated, such as Gravure coating.

For multiple layers of organic polymer coatings deposited in the PML process, take up reel 41, with the sheet wound thereon, functions as the pay out reel 37, and the process is repeated as desired by coating in both directions. The roll of sheet is removed from the vacuum system for use.

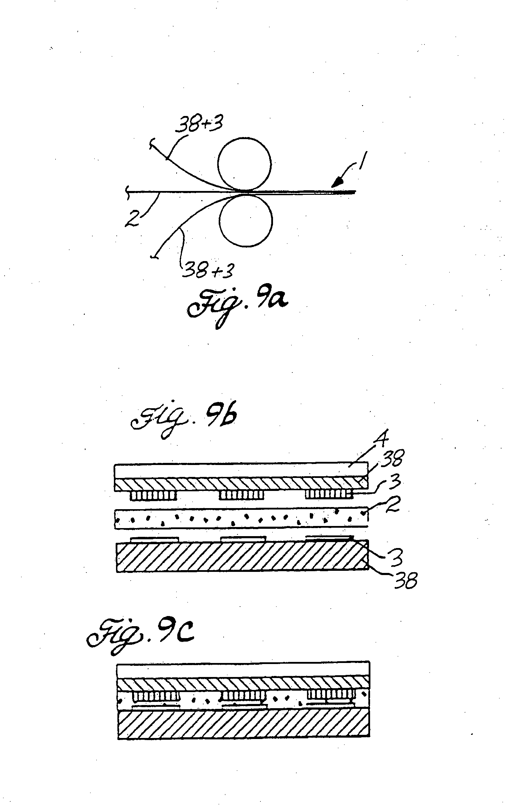

FIG. 9a illustrates a laminating process for the FPD where the coated plastic substrate and display medium are bonded together with an adhesive, pressure and temperature or through UV radiation. FIGs. 9b and 9c are a cross-sectional views of the FPD before and after undergoing the bonding process, respectively. The laminating process is one of the alternate methods for bonding the layers to construct the FPD. Because the layers of the present invention are thin; cracking, crazing, and delamination are avoided using processing methods of this type. FIGs. 9b and 9c illustrate the flat panel display with a protective overcoat 4 and the display medium 2.

Transparent dielectric layers with good barrier properties and a high refractive index, such as metal oxides like titanium oxide or aluminum oxide, or metal nitrides such as silicon nitride or aluminum nitride, used in combination with thin, transparent metallic film layers provide a transparent conductive barrier coating. The metal oxide or metal nitride layers are deposited at specific thicknesses to optimize the optical performance (e.g. transmittance) of a particular display. Preferably, the thin metallic film layer is sandwiched in between layers of metal oxide or metal nitride. Multiple alternating layers of metal oxides or metal nitrides, with their barrier properties, and the highly conductive metallic film layers provide increased barrier performance and conductivity for a particular display medium.

The optical and electrical performance of transparent conductive oxide coatings are also improved by mildly heating during deposition or post-annealing the coated substrate. Even though the substrate was heated to a moderate temperature of only 65 °C, the resistivity of the ITO was still low enough to effectively operate as an electrode, because of the thin layer of ITO. See the Experimental Results below.

In an alternative embodiment, a thin conductive metal nitride layer is substituted for one or more thin metallic film layers. Metal oxide orTCO layers are utilized with the metal nitride layer for enhancing both the optical and electrical performance characteristics. Metal nitrides have good gas barrier properties. However, to maintain the preferred moisture and oxygen permeability, there is a minimum thickness of the metal nitride layer. Because of the higher optical transparency silicon nitride thin films, for example, are attractive candidates for flexible FPD as barrier layers for atmospheric gases.

In another alternative embodiment, at least one of the metallic film layers is replaced with a polymer layer formed via the PML processes.

### RESULTS OF CONDUCTED EXPERIMENTS

The plastic substrate for a flat panel display has a very low oxygen and water vapor permeability, a surface roughness much less than the barrier film thickness, a high Tg (the glass transition temperature) to allow a higher temperature and/or higher energy ITO deposition process, and a high transparency with low ND (index of refraction) birefringence.

Defects in the coated layers limit the barrier properties. For instance, rough substrates, particulates, and roller contact damage the coated layers. Rough substrates with thin film barriers are smoothed and prevented from damage by roller contact with an organic basecoat and polymer top coat multilayers, respectively.

Multiple layers of TCO's deposited on the substrate achieve lower surface resistivity than a single thick layer of TCO. Further, the multiple TCO layers act as electrodes connected in parallel. Using non-stoichiometric dielectric of a group including silicon oxides, aluminum oxides, and silicon nitrides, allow for the fabrication all efficient thin film barriers for flexible plastic films.

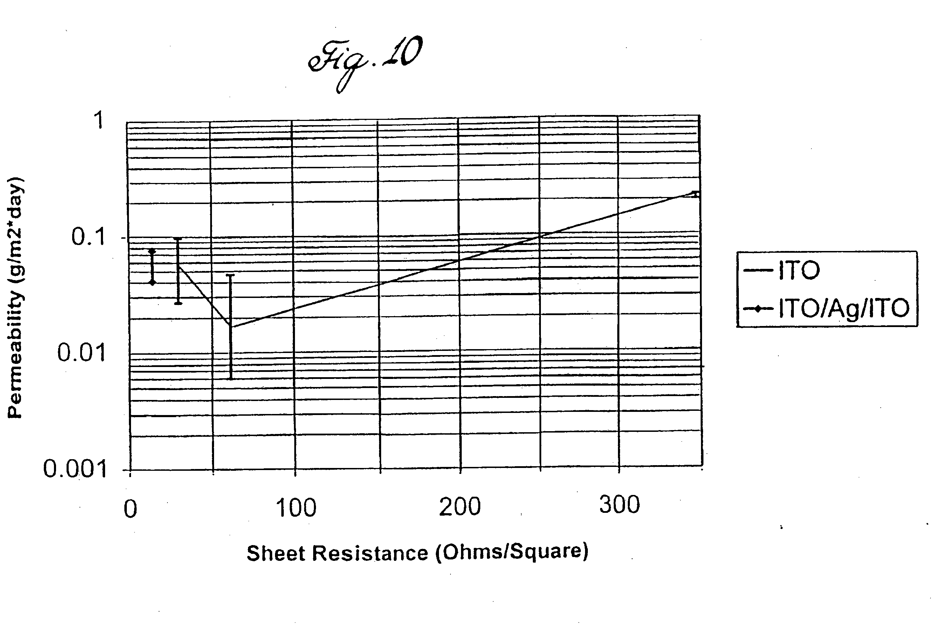

Measured data for films made of sputtered ITO exhibited exceptional barrier properties. The optical, electrical and barrier properties were measured for ITO sputter-deposited directly onto a PET substrate, and also measured with a PML acrylic base coat over the substrate before deposition of the ITO, in a roll-to-roll (web) coating process. See FIGS. 10-13, and descriptions of the Figures below. The typical performance of a single ITO layer deposited on a base coated PET substrate is ≥ 85%T (Transmittance) and ≤ 80 ohms/square. The ITO layer has a physical thickness of about 140 nm, for a one-half wave optical thickness, while the PET substrate has a thickness of about 0.007". For the single layer ITO film, oxygen permeability ranged from 0.005 to 0.05 oxygen cc/m²/day, while the water permeability ranged from 0.005 to 0.05 g/m²/day.

FIG. 10 discloses a chart showing water permeability of ITO film, as well as ITO sandwiching a silver layer, each deposited on a PET substrate versus ITO film resistance. No smoothing base coat was applied to the substrate in either case. First, the ITO layer was DC sputter deposited onto a PET substrate. The deposited ITO film is sputtered from a metal target in a web coater. The vertical lines shown connect the midpoints of the range of permeability results at each measured resistance for the ITO film sheet. The chart shows that the permeability dips to a minimal value of approximately 0.006 g/m² day at a resistance of about 60 ohms/square. The permeability reaches a maximum of approximately 0.21 g/m² day at a resistance of about 350 ohms/square. Second, for a silver layer sandwiched in between ITO film layers over the substrate, the approximate permeability range was 0.04 to 0.075 g/m² day for the sheet resistance at about 12 ohms/square.

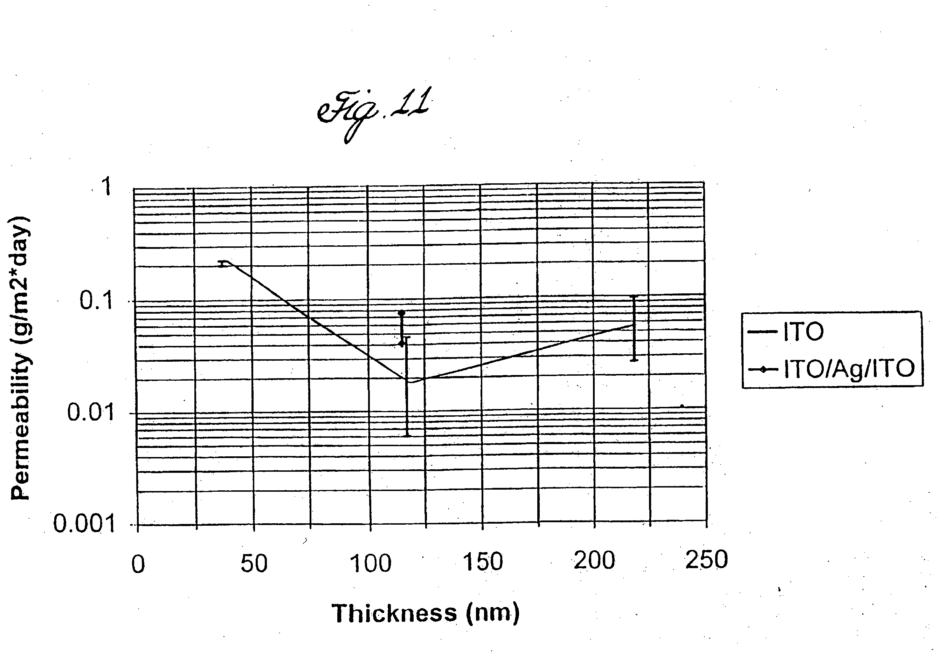

FIG. 11 discloses a chart showing water permeability of ITO film, as well as ITO sandwiching a silver layer, each deposited on a PET substrate versus ITO film sheet thickness. First, the ITO layer alone is analyzed in the same manner as above. The chart shows that the permeability dips to a minimal value of approximately 0.006 g/m² day at a thickness of about 120 nm. The permeability reaches a maximum of approximately 0.21 g/m² day at a thickness of about 40 nm. Second, for the substrate with the sandwiched silver layer, the approximate permeability range was 0.04 to 0.075 g/m² day for a sheet thickness of approximately 120 nm.

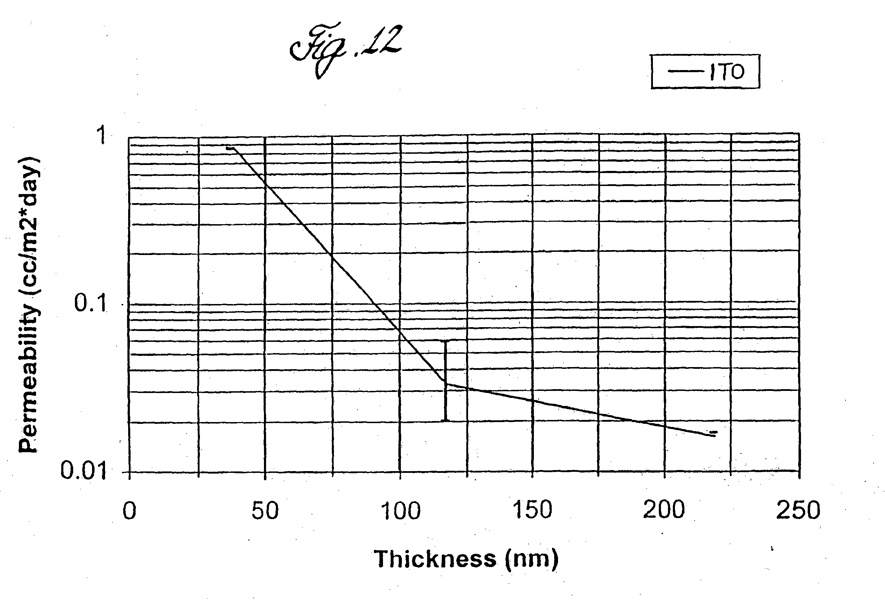

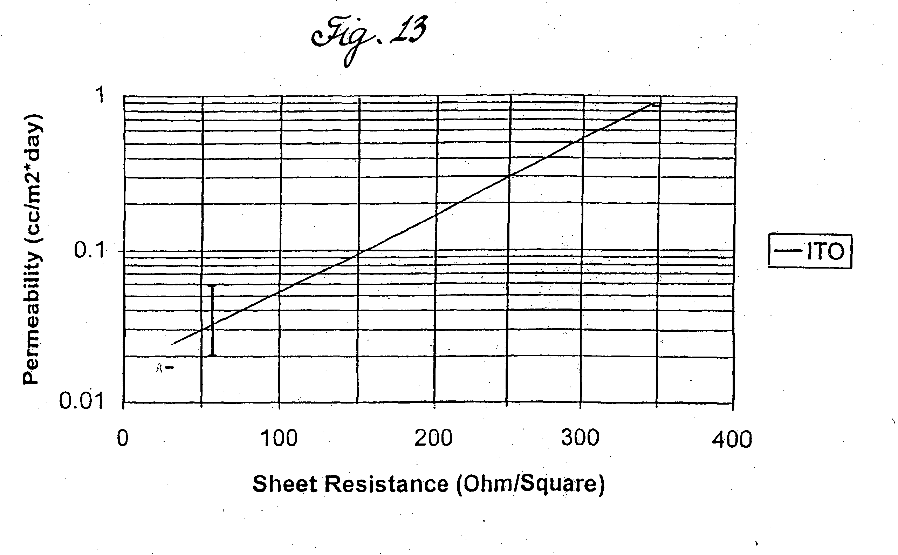

FIGs. 12 and 13 disclose charts showing oxygen permeability of ITO film deposited on a PET substrate versus ITO film sheet thickness and sheet resistivity, respectively. FIG. 12 shows that the permeability dips to a minimal value of approximately 0.017 g/m² day at a thickness of about 220 nm. The permeability reaches a maximum of approximately 0.9 cc/m² day at a thickness of about 40 nm.

As shown Table 1, alternating barrier layers of PML deposited organic polymers and dielectrics have permeation rates below the limits of the instruments, which is 0.005 g/m²*day for Permatran-W 3/31, an instrument for measuring water vapor transmission rates and 0.005 cc/m²*day for Ox-Tran 2/20, an instrument for measuring oxygen transmission rates.

A transparent dielectric barrier layer or a "single layer" of TCO deposited on the substrate has suitable barrier properties for the plastic FPD. The preferable barrier properties vary by the type of display technology: liquid crystal display (LCD) and organic light emitting display (OLED). The acceptable value of vapor permeation with plastic substrates for FPD depends on the sensitivity of the specific display technology utilized. For example, the LCD is much less sensitive to vapor permeation than the OLED. For the LCD, oxygen permeability is preferably in the range of about 0.01 to 0.1 cc/m²*day, while water vapor permeability is preferably in the range of about 0.01 to 0.1 glm²*day. For OLED, permeabilities of ≤ 0.001 cc/m²*day for oxygen, and ≤ 0.001 g/m²*day for moisture (water vapor) are preferred.

A polymer OLED and a small molecule OLED describes the two basic technologies for the layer that emits light in the OLED. For polymer OLED's, the light emitting material is deposited by flow coating, spin coating, gravure coating, meniscus coating, curtain coating or any common liquid coating or printing techniques. The small molecule OLED is normally thermally evaporated in'a vacuum, but is also processed with nonvacuum coating methods. If the ITO layer is deposited by nonvacuum processes such as by screen printing, the process of the present invention is entirely nonvacuum. Alternatively, the process of the present invention takes place by both vacuum and nonvacuum methods. Preferably, the process takes place in a vacuum both to avoid contamination by particulates, and to avoid moisture and oxygen. Superior barrier films and other films are provided by the cleaner vacuum process.

As shown in FIGS. 10 and 11 for the LCD, as long as the sheet resistance is below about 250 ohms/square, and as long as the ITO film thickness is between about 75 and 225 nm, the preferred water permeability for the LCD is met. As shown in FIG. 12, the preferred oxygen permeability for the LCD is met as long as the ITO film thickness is above about 85 nm and as long as the sheet resistance is below about 150 ohm/square. Because of the lower permeabilities preferred for the emissive displays (e.g. OLED), the barrier capability is enhanced by multilayer dielectric or TCO barriers in combination with PML processed polymer coatings (i.e. composite barrier layers of PML deposited organic polymer layers, dielectric layers and/or TCO layers).

Two charts of a test (not shown herein) illustrate water vapor and oxygen permeability versus ITO thickness. The measured results for semi-reactively and reactively sputtered ITO, as well as the differences between a single ITO layer and two ITO layers (with a polymer layer in between the two layers) made with a semi-reactive process, are as follows; 'Semi-reactively' sputtered refers to DC magnetron sputtered from a ceramic target. The differences between the two processes are due to the specific process parameters, and not inherent to the process type. As shown, for the same thickness, the two ITO layers have higher conductivity and lower permeability as compared to the single ITO layer. Further, the two ITO layers have higher electrical performance, because the single ITO layer cracks and/or crazes.

The preferred thickness for the deposited layers is different for conductivity and barrier properties. The deposited film is thick in order to have conductive properties. Also, if a film layer is too thin it will not have adequate barrier properties. The critical thickness for these layers varies with the material and, to a lesser extent, how the layer is deposited. For ITO, the critical minimal thickness is about 20 nanometers (or 200 angstroms). The lower limits for some of the metal oxides are about 10 to 30 nanometer range in packaging. Generally, 5-10 nanometers is the minimum thickness for adequate barrier properties. however, enhanced conductive properties result film thickness in the range of about 20 nanometers to 300 nanometers. If the film is thicker than that range, then the film starts cracking, and hence, loses conductivity and barrier properties. For maximizing optical transmission, it is well known that optical thicknesses of thin films are selected. The typical physical thickness is 20-300 nanometers for ITO on a flexible substrate.

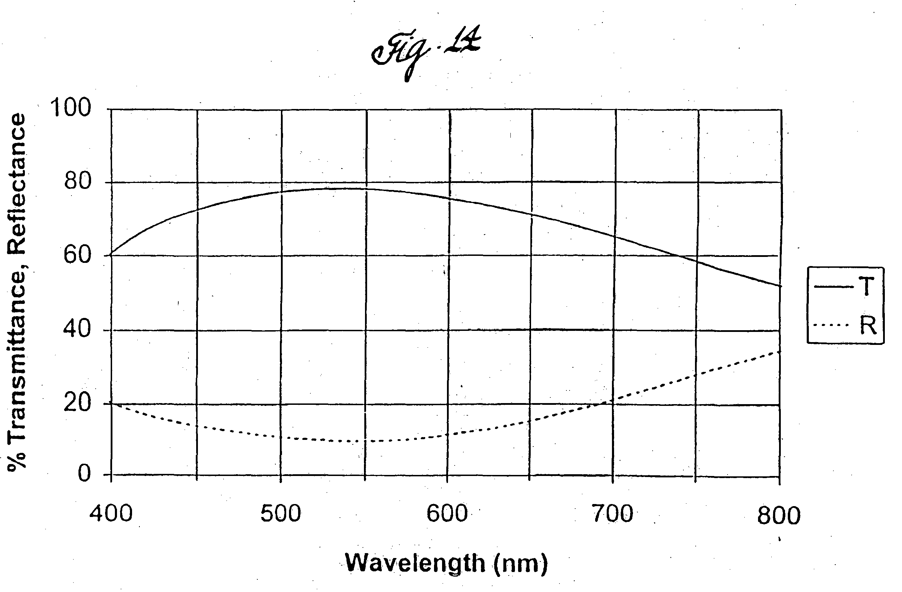

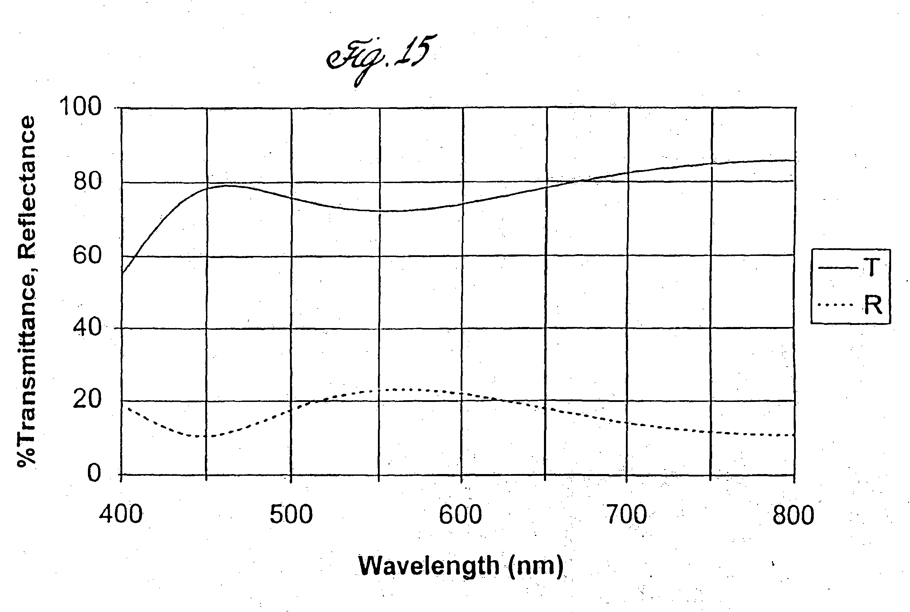

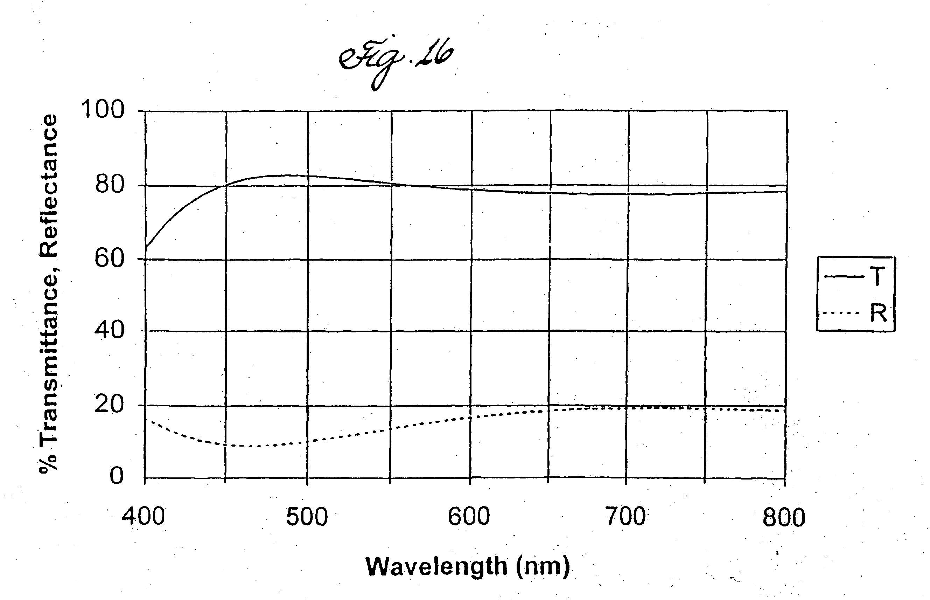

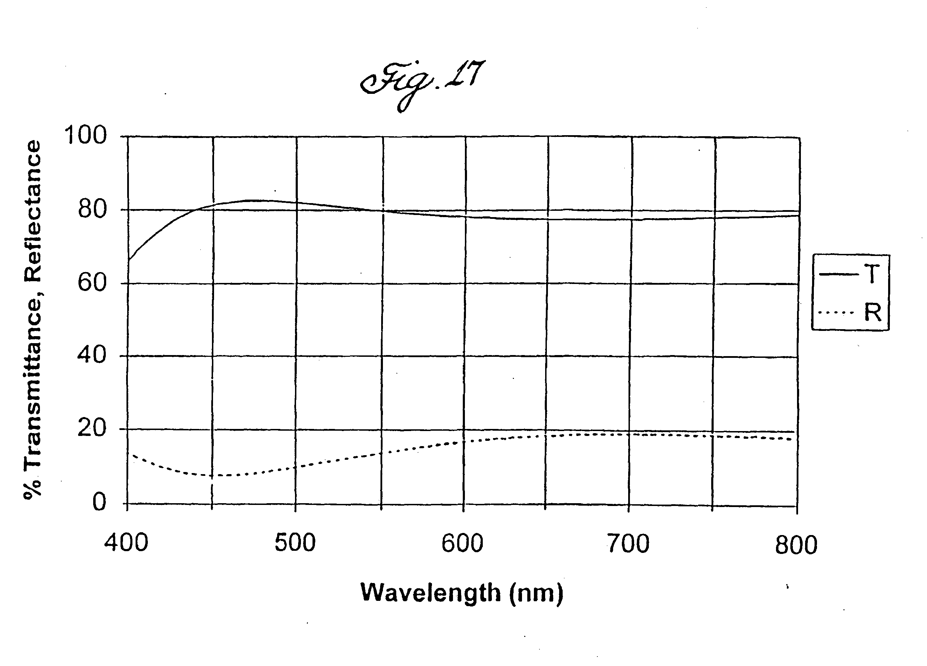

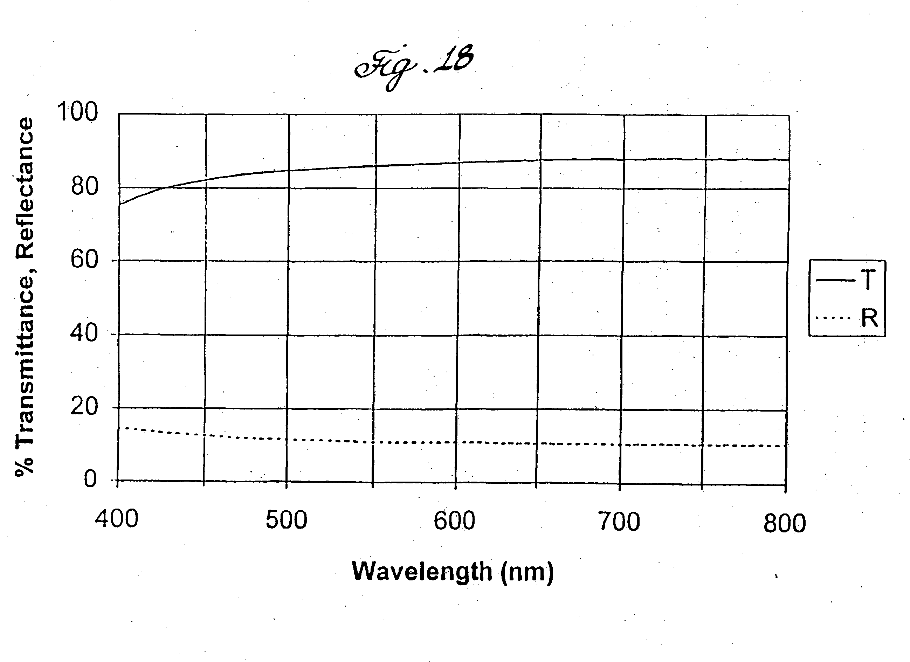

As seen in FIGS. 15-18, generally, regardless of the sheet resistance, the percentage of spectral transmittance and reflectance remains relatively constant. For example, at about a wavelength of 500 nm, the transmittance percentage is about 80% for resistance ranging from 29 ohms/square to 347 ohms/square. DC sputter deposited ITO on a hardcoated PET substrate exhibited a resistivity of 46.9 Ohms/square, which is approximately 5X10⁻⁴ ohm-cm, and a visible transmittance of 84.7%. Generally, the transmittance increases (and the reflectance decreases) as the plasma wavelength increases. There is always a compromise between high optical transmittance and high conductivity. In contrast, for FIG. 14 (a more preferred embodiment of the present invention), at the higher wavelengths, the transmittance decreases (and the reflectance increases).

Another test (not shown herein) illustrates the Transmittance and Reflectance of semi-reactively sputtered ITO on a PET substrate for various thicknesses versus wavelength. The transmittance and reflectance of a substrate coated with a polymer layer and an ITO layer, a substrate with an ITO layer, and a substrate with two ITO layers (with a polymer layer in between the two ITO layers) are illustrated. Generally, transmittance and conductivity are inversely related. Improved optical performance is achieved by controlling the thickness and index of the polymer layers.

For a transparent electrode, conductivity varies with display technology and addressing method, The surface resistivity for LCD's is about 50-300 Ohm/square, and for OLED's is about 10-100 Ohm/square. The corresponding visible transmittance for LCD's is about 90%, and for OLED's is about 80-85%. The thickness of the conductor layer is compatible with the vacuum web coating processing for the flexible plastic substrate.

Table 1 shows the test results for oxygen and water vapor transmission rates of various samples of a substrate coated with a single ITO layer with different ohm/square coatings and a substrate coated with an ITO layer, a metal layer, and another ITO layer. The test conditions were as follows: the temperature was at 23°C/73.4°F. On each side of the barrier for the oxygen transmission rate tests, the relative humidity was 0%. On one side of the barrier for the water vapor transmission rate tests, the relative humidity was 100%, but the other side of the barrier had a relative humidity of 0%.

The first eight samples are a single layer ITO with different resistances coated onto a plastic substrate. For example, the '25-1' is the first sample of the resistance of 25 ohm/square; whereas '25-2' is the second sample from the same lot. The last two samples are of a substrate coated with an ITO layer, a metal coating, and another ITO layer, with a resistance of 10 ohm/square. This 3 layer configuration is called "optically enhanced metal," or "induced transmission filter," and has similar characteristics as a single TCO layer. With the optically enhanced metal good conductivity, transmission and barrier properties are achieved. Preferably the ITO layers, which antireflect the metal, each have a thickness of about 30-60 nanometers. In several instances, the samples were tested two times. The second column for the 25 and 60 ohm/square reflects the results of the second test.

**Table 1**

| Sample | Water Vapor Transmission Rate (g/m²*day) | | Oxygen Transmission Rate (cc/m²*day) | |
|---|---|---|---|---|
| 25-1 | 0.026 | <0.005¹ | 0.017 | 0.087 |
| 25-2 | 0.097 | <0.005¹ | 0.584 | 0.257 |
| 60-1 | 0.042 | | 0.059 | 0.071 |
| 60-2 | 0.050 | | 0.204 | 0.090 |
| 60-3 | 0.007 | | <0.005² | |
| 60-4 | <0.005¹ | | 0.014 | |
| 300-1 | 0.243 | | 0.861 | |
| 300-2 | 0.232 | | 0.864 | |
| M-10-1 | 0.076 | | 0.035 | |
| M-10-2 | 0.041 | | 0.024 | |

| | | | | |
|---|---|---|---|---|
| ¹ The actual water vapor transmission rate was at least as low as the lower limit of the instrument. Permatran-W 3/31, 0.005 g/m²*day. ² The actual oxygen transmission rate was at least as low as the lower limit of the instrument. Ox-Tran 2/20, 0.005 cc/m²*day. | | | | |

Table 2 compares permeation rates for different coatings, including multiple dyad (an acrylate/oxide pair) layers, on polyethylene terephthalate (PET) and oriented polypropylene (OPP) substrates. As shown, a single dyad on a substrate has high permeation resistance for oxygen and moisture. In some instances, two oxygen transmission rate tests were conducted, and the results were shown in a second column. Footnote ¹ denotes the typical permeation rate for the PET substrate.

**Table 2**

| Sample | Water Vapor Transmission Rate (g/m²*day) | Oxygen Transmission Rate (cc/m²*day) | |
|---|---|---|---|
| 2 mil PET | 30.5, 272¹ per micron film thickness | 5.3, 1550' per micron film thickness | |
| Food packaging - target values (PET/oxide) | 1.55 | 1.5 | |
| 2 mil PET/single dyad (23 °C) | <0.0078 | 0.03 | |
| 2 mil PET/ seven dyads (23 °C) | <0.0078 | <0.016 | |
| 7 mil PET/ hardcoat (23 °C) | 7.6 | - | |
| 7 mil PET/hardcoat/ single dyad (38 °C) | <0.0078, 90% Relative Humidity (RH), 100% O₂ | 0.2682, 100% RH | 0.6061, 100% RH |
| 7 mil PET/ hardcoat/ single dyad/ ITO (38 °C) | <0.0078, 90% RH, 100% O₂ | 0.0098, 100% RH | 0.0128, 100% RH |
| PET/oxide | 0.7-1.5 | 0.15-0.9 | |
| PET/Al | 0.6 | 0.17 | |
| OPP, copolymer, 1 mil | 1800 | 1.3 | |
| OPP/ oxide | 17-546 | 0.08-0.4 | |
| OPP/Al | 20 | 0.11 | |

**Table 3**

| Sample | Water Vapor Transmission Rate (g/100in²*24 hours) | Oxygen Transmission Rate (cc/100in²*24 hours) |
|---|---|---|
| A | <0.001 | <0.001 |
| B | <0.001 | <0.001 |
| C | <0.001 | <0.001 |
| D | <0.001 | <0.001 |
| E | 0.369 | 1.971 |
| F | 0.370 | 1.934 |
| G | 0.340 | 1.834 |
| H | 0.377 | 1.888 |

Samples A through D are layers of polymer (PML)/oxide/polymer (PML) on 2 mil PET. Samples E through H are 2 mil PET only.

Although the present invention has been described and is illustrated with respect to various embodiments thereof, it is to be understood that it is not to be so limited, because changes and modifications may be made therein which are within the full intended scope of this invention as hereinafter claimed. In particular, the structure disclosed for flat panel displays is also used with other display technologies, such as polymer light emitting diode (PLED) and light emitting diode (LED) displays.

## Claims

1. A composite substrate for use in flat panel displays (1), packaging or electro luminescence lamps comprising:
a plastic substrate (38); and
a first conductive barrier material layer (3) deposited over the plastic substrate (38), the conductive barrier material layer (3) including one of a thin transparent conductive oxide (22) and a metal nitride (14), **characterized in that** the composite substrate further comprises multiple alternating sublayer pairs of a vapor deposited crosslinked organic monomer and a transparent conductive oxide (22).

2. The composite substrate of claim 1 further comprising a first organic polymer deposited over the plastic substrate (38).

3. The composite substrate of claim 1 further comprising a first organic polymer deposited over the conductive barrier layer (3).

4. The composite substrate of claim 2 further comprising a second organic polymer deposited over the conductive barrier layer (3).

5. The composite substrate of claim 1 further comprising one or more additional layers of conductive barrier material deposited over the plastic substrate (38), the additional layers of conductive barrier material having the same material as the first conductive barrier material (3).

6. The composite substrate of claim 5 further comprising one or more additional layers deposited over the previously deposited conductive barrier material layer, respectively, each additional layer including one of an organic polymer, a thin transparent dielectric, a thin transparent metallic film (12) and a thin transparent conductive oxide (22).

7. The composite substrate of claim 6 wherein the thin transparent metallic film (12) is aluminum.

8. The composite substrate of claim 6 wherein the thin transparent metallic film (12) is silver.

9. The composite substrate of claim 1 wherein the plastic substrate (38) is one of a polyester and a polyolefin.

10. The composite substrate of claim 1 wherein the transparent conductive oxide (22) is tin doped indium oxide.

11. The composite substrate of claim 6 wherein the transparent dielectric barrier is one of silicon oxide and aluminum oxide.

12. A process for fabricating a composite substrate for use in flat panel display (1) or packaging comprising:
providing a plastic substrate (38); and
depositing a first conductive barrier material layer (3) over the plastic substrate (38), the conductive barrier material layer (3) including one of a thin transparent conductive oxide (22) and a metal nitride (14), **characterized in that** the process further comprises depositing multiple alternating sublayer pairs of a vapor deposited crosslinked organic monomer and a transparent conductive oxide (22).

13. The process of claim 12 further comprising depositing a first organic polymer over the plastic substrate (38).

14. The process of claim 12 further comprising depositing a first organic polymer over the conductive barrier layer (3).

15. The process of claim 13 further comprising depositing a second organic polymer over the conductive barrier layer (3).

16. The process of claim 12 further comprising depositing one or more additional layers of conductive barrier material over the plastic substrate (38), the additional layers of conductive barrier material having the same material as the first conductive barrier material (3).

17. The process of claim 16 further comprising depositing one or more additional layers over the previously deposited conductive barrier material layer, respectively, each additional layer including one of an organic polymer, a thin transparent dielectric, a thin transparent metallic film (12) and a thin transparent conductive oxide (22).

18. The process of claim 13 further comprising vapor depositing and crosslinking an organic monomer to form the polymer layer.

19. The process of claim 13 further comprising liquid smoothing an organic polymer to form the polymer layer.

20. The process of claim 13 further comprising depositing the polymer layer over the previously deposited layer before the previously deposited layer contacts a surface.

21. The process of claim 17 wherein the thin transparent metallic film (12) is aluminum.

22. The process of claim 17 wherein the thin transparent metallic film (12) is silver.

23. The process of claim 12 wherein the plastic substrate (38) is one of a polyester and a polyolefin.

24. The process of claim 12 wherein the transparent conductive oxide (22) coating is tin doped indium oxide.

25. The process of claim 17 wherein the transparent dielectric barrier is one of silicon oxide and aluminum oxide.

26. The process of claim 25 further comprising depositing the aluminum oxide by one of evaporation of the aluminum which is then converted to an oxide in an oxygen plasma and electron beam evaporation.

27. The process of claim 17 further comprising depositing the dielectric layer by a plasma assisted chemical vapor deposition process using one of an oxidizing carrier gas and inert carrier gas.

28. The process of claim 21 further comprising depositing the aluminum layer by one of vacuum metallizing and sputtering.

29. The process of claim 12 wherein the transparent conductive oxide (22) is deposited by sputtering.

30. The process of claim 29 further comprising providing hydrogen in a plasma of a vacuum chamber used in the sputtering process of the transparent conductive oxide (22).

31. The process of claim 12 further comprising mildly annealing the substrate (38) before deposition of layers thereon.

32. The process of claim 31 wherein the substrate (38) is annealed to approximately 65°C.

## Patentansprüche

1. Kompositsubstrat zur Verwendung in Flachbildschirmen (1), Verpackungen oder Elektrolumineszenzlampen, umfassend:
ein Kunststoffsubstrat (38) und
eine erste leitfähige Sperrmaterialschicht (3), die auf dem Kunststoffsubstrat (38) abgeschieden ist, wobei die leitfähige Sperrmaterialschicht (3) eines aus einem dünnen transparenten leitfähigen Oxid (22) und einem Metallnitrid (14) umfasst, **dadurch gekennzeichnet, dass** das Kompositsubstrat ferner mehrere alternierende Unterschichtpaare aus einem aufgedampften vernetzten organischen Monomer und einem transparenten leitfähigen Oxid (22) umfasst.

2. Kompositsubstrat nach Anspruch 1, ferner umfassend ein erstes organisches Polymer, das auf dem Kunststoffsubstrat (38) abgeschieden ist.

3. Kompositsubstrat nach Anspruch 1, ferner umfassend ein erstes organisches Polymer, das auf der leitfähigen Sperrschicht (3) abgeschieden ist.

4. Kompositsubstrat nach Anspruch 2, ferner umfassend ein zweites organisches Polymer, das auf der leitfähigen Sperrschicht (3) abgeschieden ist.

5. Kompositsubstrat nach Anspruch 1, ferner umfassend eine oder mehrere zusätzliche Schichten aus leitfähigem Sperrmaterial, die auf dem Kunststoffsubstrat (38) abgeschieden sind, wobei die zusätzlichen Schichten leitfähigen Sperrmaterials dasselbe Material aufweisen wie das erste leitfähige Sperrmaterial (3).

6. Kompositsubstrat nach Anspruch 5, ferner umfassend eine oder mehrere zusätzliche Schichten, die jeweils auf der vorher abgeschiedenen leitfähigen Sperrmaterialschicht abgeschieden sind, wobei jede zusätzliche Schicht eines aus einem organischen Polymer, einem dünnen transparenten Dielektrikum, einem dünnen transparenten metallischen Film (12) und einem dünnen transparenten leitfähigen Oxid (22) umfasst.

7. Kompositsubstrat nach Anspruch 6, wobei der dünne transparente metallische Film (12) Aluminium ist.

8. Kompositsubstrat nach Anspruch 6, wobei der dünne transparente metallische Film (12) Silber ist.

9. Kompositsubstrat nach Anspruch 1, wobei das Kunststoffsubstrat (38) eines aus einem Polyester und einem Polyolefin ist.

10. Kompositsubstrat nach Anspruch 1, wobei das transparente leitfähige Oxid (22) Indiumzinnoxid ist.

11. Kompositsubstrat nach Anspruch 6, wobei die transparente dielektrische Sperre eines aus Siliziumoxid und Aluminiumoxid ist.

12. Verfahren zur Herstellung eines Kompositsubstrats zur Verwendung in Flachbildschirmen (1) oder Verpackungen, umfassend:
Bereitstellen eines Kunststoffsubstrats (38) und
Abscheiden einer ersten leitfähigen Sperrmaterialschicht (3) auf dem Kunststoffsubstrat (38), wobei die leitfähige Sperrmaterialschicht (3) eines aus einem dünnen transparenten leitfähigen Oxid (22) und einem Metallnitrid (14) umfasst, **dadurch gekennzeichnet, dass** das Verfahren ferner das Abscheiden mehrerer alternierender Unterschichtpaare aus einem aufgedampften vernetzten organischen Monomer und einem transparenten leitfähigen Oxid (22) umfasst.

13. Verfahren nach Anspruch 12, ferner umfassend das Abscheiden eines ersten organischen Polymers auf dem Kunststoffsubstrat (38).

14. Verfahren nach Anspruch 12, ferner umfassend das Abscheiden eines ersten organischen Polymers auf der leitfähigen Sperrschicht (3).

15. Verfahren nach Anspruch 13, ferner umfassend das Abscheiden eines zweiten organischen Polymers auf der leitfähigen Sperrschicht (3).

16. Verfahren nach Anspruch 12, ferner umfassend das Abscheiden einer oder mehrerer zusätzlichen Schichten leitfähigen Sperrmaterials auf dem Kunststoffsubstrat (38), wobei die zusätzlichen Schichten leitfähigen Sperrmaterials dasselbe Material aufweisen wie das erste leitfähige Sperrmaterial (3).

17. Verfahren nach Anspruch 16, ferner umfassend das Abscheiden jeweils einer oder mehrerer zusätzlicher Schichten auf der vorher abgeschiedenen leitfähigen Sperrmaterialschicht, wobei jede zusätzliche Schicht eines aus einem organischen Polymer, einem dünnen transparenten Dielektrikum, einem dünnen transparenten metallischen Film (12) und einem dünnen transparenten leitfähigen Oxid (22) umfasst.

18. Verfahren nach Anspruch 13, ferner umfassend das Dampfabscheiden und das Vernetzen eines organischen Monomers zum Bilden der Polymerschicht.

19. Verfahren nach Anspruch 13, ferner umfassend das flüssige Glätten eines organischen Polymers zum Bilden der Polymerschicht.

20. Verfahren nach Anspruch 13, ferner umfassend das Abscheiden der Polymerschicht auf der vorher abgeschiedenen Schicht, bevor die vorher abgeschiedene Schicht mit einer Oberfläche in Kontakt kommt.

21. Verfahren nach Anspruch 17, wobei der dünne transparente metallische Film (12) Aluminium ist.

22. Verfahren nach Anspruch 17, wobei der dünne transparente metallische Film (12) Silber ist.

23. Verfahren nach Anspruch 12, wobei das Kunststoffsubstrat (38) eines aus einem Polyester und einem Polyolefin ist.

24. Verfahren nach Anspruch 12, wobei die Beschichtung aus transparentem leitfähigem Oxid (22) Indiumzinnoxid ist.

25. Verfahren nach Anspruch 17, wobei die transparente dielektrische Sperre eines aus Siliziumoxid und Aluminiumoxid ist.

26. Verfahren nach Anspruch 25, ferner umfassend das Abscheiden des Aluminiumoxids durch eines aus Verdampfung des Aluminiums, das dann in einem Sauerstoffplasma in ein Oxid umgewandelt wird, und Elektronenstrahlverdampfung.

27. Verfahren nach Anspruch 17, ferner umfassend das Abscheiden der dielektrischen Schicht durch ein plasma-unterstütztes chemisches Aufdampfungsverfahren unter Verwendung eines aus oxidierendem Trägergas und inertem Trägergas.

28. Verfahren nach Anspruch 21, ferner umfassend das Abscheiden der Aluminiumschicht durch eines aus Vakuummetallisierung und Sputtern.

29. Verfahren nach Anspruch 12, wobei das transparente leitfähige Oxid (22) durch Sputtern abgeschieden wird.

30. Verfahren nach Anspruch 29, ferner umfassend das Bereitstellen von Wasserstoff in einem Plasma einer Vakuumkammer, die in dem Sputterverfahren des transparenten leitfähigen Oxids (22) verwendet wird.

31. Verfahren nach Anspruch 12, ferner umfassend das leichte Glühen des Substrats (38), bevor Schichten darauf abgeschieden werden.

32. Verfahren nach Anspruch 31, wobei das Substrat (38) auf etwa 65 °C geglüht wird.

## Revendications

1. Substrat composite pour une utilisation dans les affichages à écran plat (1), l'emballage ou les lampes à électroluminescence comprenant :
un substrat en plastique (38) ; et
une première couche de matériau de barrière conducteur (3) déposée sur le substrat en plastique (38), la couche de matériau de barrière conducteur (3) incluant un matériau parmi un oxyde conducteur transparent mince (22) et un nitrure de métal (14) **caractérisé en ce que** le substrat composite comprend en outre plusieurs paires de sous-couches alternées d'un monomère organique réticulé déposé en phase vapeur et d'un oxyde conducteur transparent (22).

2. Substrat composite selon la revendication 1, comprenant en outre un premier polymère organique déposé au-dessus du substrat en plastique (38).

3. Substrat composite selon la revendication 1, comprenant en outre un premier polymère organique déposé au-dessus de la couche de barrière conductrice (3).

4. Substrat composite selon la revendication 2, comprenant en outre un deuxième polymère organique déposé au-dessus de la couche de barrière conductrice (3).

5. Substrat composite selon la revendication 1, comprenant en outre une ou plusieurs couches supplémentaires de matériau de barrière conducteur déposé au-dessus du substrat en plastique (38), les couches supplémentaires de matériau de barrière conducteur possédant le même matériau que le premier matériau de barrière conducteur (3).

6. Substrat composite selon la revendication 5, comprenant en outre une ou plusieurs couches supplémentaires déposées au-dessus de la couche de matériau de barrière conducteur précédemment déposée, respectivement, chaque couche supplémentaire incluant un matériau parmi un polymère organique, un diélectrique transparent mince, un film métallique transparent mince (12) et un oxyde conducteur transparent mince (22).

7. Substrat composite selon la revendication 6, dans lequel le film métallique transparent mince (12) est de l'aluminium.

8. Substrat composite selon la revendication 6, dans lequel le film métallique transparent mince (12) est de l'argent.

9. Substrat composite selon la revendication 1, dans lequel le substrat en plastique (38) est un matériau parmi un polyester et une polyoléfine.

10. Substrat composite selon la revendication 1, dans lequel l'oxyde conducteur transparent (22) est de l'oxyde d'indium dopé à l'étain.

11. Substrat composite selon la revendication 6, dans lequel la barrière diélectrique transparente est un matériau parmi l'oxyde de silicium et l'oxyde d'aluminium.

12. Procédé de fabrication d'un substrat composite pour une utilisation dans un affichage à écran plat (1) ou un emballage, comprenant :
la fourniture d'un substrat en plastique (38) ; et
le dépôt d'une première couche de matériau de barrière conducteur (3) sur le substrat en plastique (38), la couche de matériau de barrière conducteur (3) incluant un matériau parmi un oxyde conducteur transparent mince (22) et un nitrure de métal (14), **caractérisé en ce que** le procédé comprend en outre le dépôt de plusieurs paires de sous-couches alternées d'un monomère organique réticulé déposé en phase vapeur et d'un oxyde conducteur transparent (22).

13. Procédé selon la revendication 12, comprenant en outre le dépôt d'un premier polymère organique au-dessus du substrat en plastique (38).

14. Procédé selon la revendication 12, comprenant en outre le dépôt d'un premier polymère organique au-dessus de la couche de barrière conductrice (3).

15. Procédé selon la revendication 13, comprenant en outre le dépôt d'un deuxième polymère organique au-dessus de la couche de barrière conductrice (3).

16. Procédé selon la revendication 12, comprenant en outre le dépôt d'une ou plusieurs couches supplémentaires de matériau de barrière conducteur au-dessus du substrat en plastique (38), les couches supplémentaires de matériau de barrière conducteur possédant le même matériau que le premier matériau de barrière conducteur (3).

17. Procédé selon la revendication 16, comprenant en outre le dépôt d'une ou plusieurs couches supplémentaires au-dessus de la couche de matériau de barrière conducteur précédemment déposée, respectivement, chaque couche supplémentaire incluant un matériau parmi un polymère organique, un diélectrique transparent mince, un film métallique transparent mince (12) et un oxyde conducteur transparent mince (22).

18. Procédé selon la revendication 13, comprenant en outre le dépôt en phase vapeur et la réticulation d'un monomère organique pour former la couche polymère.

19. Procédé selon la revendication 13, comprenant en outre le lissage par liquide d'un polymère organique de façon à former la couche polymère.

20. Procédé selon la revendication 13, comprenant en outre le dépôt de la couche polymère au-dessus de la couche précédemment déposée avant que la couche précédemment déposée ne vienne en contact avec une surface.

21. Procédé selon la revendication 17, dans lequel le film métallique transparent mince (12) est de l'aluminium.

22. Procédé selon la revendication 17, dans lequel le film métallique transparent mince (12) est de l'argent.

23. Procédé selon la revendication 12, dans lequel le substrat en plastique (38) est un matériau parmi un polyester et une polyoléfine.

24. Procédé selon la revendication 12, dans lequel le revêtement d'oxyde conducteur transparent (22) est de l'oxyde d'indium dopé à l'étain.

25. Procédé selon la revendication 17, dans lequel la barrière diélectrique transparente est un matériau parmi l'oxyde de silicium et l'oxyde d'aluminium.

26. Procédé selon la revendication 25, comprenant en outre le dépôt de l'oxyde d'aluminium par un procédé d'évaporation de l'aluminium qui est ensuite converti en un oxyde dans un plasma d'oxygène et une évaporation par faisceau d'électrons.

27. Procédé selon la revendication 17, comprenant en outre le dépôt de la couche diélectrique par un procédé de dépôt chimique en phase vapeur assisté par plasma en utilisant un matériau parmi un gaz vecteur oxydant et un gaz vecteur inerte.

28. Procédé selon la revendication 21, comprenant en outre le dépôt de la couche d'aluminium par un procédé parmi la métallisation sous vide et la pulvérisation.

29. Procédé selon la revendication 12, dans lequel l'oxyde conducteur transparent (22) est déposé par pulvérisation.

30. Procédé selon la revendication 29, comprenant en outre la fourniture d'hydrogène dans un plasma d'une chambre à vide utilisée dans le procédé de pulvérisation de l'oxyde conducteur transparent (22).

31. Procédé selon la revendication 12, comprenant en outre un recuit modéré du substrat (38) avant dépôt des couches sur celui-ci.

32. Procédé selon la revendication 31, dans lequel le substrat (38) est recuit à approximativement 65 °C.
